# EUROPEAN PATENT APPLICATION

(11) **EP 4 708 295 A1**
(43) Date of publication of application: **11.03.2026**
(21) Application number: 23946529.7
(22) Date of filing: 28.12.2023
(51) Int. Cl.: G11C 11/406

(54) **REFRESH CONTROL CIRCUIT AND MEMORY**

(30) Priority: 25.07.2023 CN 202310931546
(71) Applicant: CXMT Corporation, Hefei City, Anhui Province 230601 (CN)
(72) Inventor: DONG, Ping, Hefei, Anhui 230601 (CN); LI, Liang, Hefei, Anhui 230601 (CN); GU, Yinchuan, Hefei, Anhui 230601 (CN)
(74) Representative: Gulde & Partner
(86) International application number: PCT/CN2023/142578
(87) International publication number: WO 2025/020454

(57) **Abstract**

The present disclosure relates to the field of semiconductor circuit design, and in particular to a refresh control circuit and a memory. The refresh control circuit includes: a count flag circuit configured to generate and output a count flag signal at an active level based on a refresh activation signal when an all-bank refresh flag signal and a same-bank refresh flag signal are active; a count processing circuit configured to receive the count flag signal and count based on the count flag signal to generate a counting result; and a first control circuit configured to receive the counting result and generate and output, when the counting result is within a first preset range, a supplementary refresh indication signal at an active level. The supplementary refresh indication signal, when active, indicates that an associated memory performs a supplementary refresh operation.

## Description

### CROSS-REFERENCE

The present disclosure claims priority to Chinese Patent Application No. 202310931546.8, filed on July 25, 2023, and entitled "REFRESH CONTROL CIRCUIT AND MEMORY", which is incorporated herein by reference in its entirety.

### TECHNICAL FIELD

The present disclosure relates to the field of semiconductor circuit designs, and in particular, to a refresh control circuit and a memory.

### BACKGROUND

A double data rate fifth-generation synchronous dynamic random-access memory (double data rate fifth-generation synchronous dynamic random-access memory, DDR5 SDRAM) is a high bandwidth memory. The DDR5 usually includes two refresh modes and two types of refresh commands. The two refresh modes include a normal refresh mode and a fine granularity refresh mode (compared with the normal refresh mode, in the fine granularity refresh mode, fewer word lines are activated in each tRFC; for example, four ACTIVE operations are performed during one tRFC in the normal refresh mode, while two ACTIVE operations are performed during one tRFC in the fine granularity refresh mode). The two types of refresh commands include an all-bank refresh command REFab and a same-bank refresh command REFsb (the all-bank refresh command REFab is used to refresh all banks of the memory, while the same-bank refresh command REFsb is used to refresh a target bank of the memory). The all-bank refresh command REFab can be generally executed in the two refresh modes, while the same-bank refresh command REFsb can only be executed in the fine granularity refresh mode. If the same-bank refresh command is issued in the normal refresh mode, the current same-bank refresh command will be masked as it cannot be executed.

With the popularization of the dynamic random access memory (dynamic random access memory, DRAM) industry, high density and low cost are no longer the only demands. The reduction in process dimension has become the development trend of DRAMs. As the process dimension continuously reduces, frequent access to a certain row increasingly exacerbates the bit flipping in its adjacent rows. Therefore, the row hammer protection has become increasingly important, requiring regular refreshing of two adjacent rows of the victim row. With the development of DRAM, various refresh modes have been introduced, and the row hammer protection is embedded in these refresh operations. However, frequent switching of refresh modes may lead to vulnerabilities in the row hammer protection.

### SUMMARY

An embodiment of the present disclosure provides a refresh control circuit. The refresh control circuit includes: a count flag circuit configured to receive refresh activation signals, an all-bank refresh flag signal, and a same-bank refresh flag signal, and generate and output, based on each refresh activation signal, one count flag signal when the all-bank refresh flag signal or the same-bank refresh flag signal is active, where the all-bank refresh flag signal indicates that an associated memory currently performs a refresh operation based on an all-bank refresh command, the same-bank refresh flag signal indicates that the associated memory currently performs a refresh operation on the last bank in each bank group based on a same-bank refresh command, the associated memory generates at least one refresh activation signal based on each all-bank refresh command or each same-bank refresh command, and the associated memory performs one refresh operation based on each refresh activation signal; a count processing circuit configured to receive the count flag signal and count based on the count flag signal to generate a counting result; and a first control circuit configured to receive the counting result and generate and output, when the counting result is within a first preset range, a supplementary refresh indication signal at an active level, where the supplementary refresh indication signal, when active, indicates that the associated memory performs a supplementary refresh operation based on the all-bank refresh command or the same-bank refresh command.

Optionally, the first control circuit is further configured to receive precharge delay signals. The precharge delay signal is a delay signal of a precharge signal, and each refresh activation signal corresponds to one precharge signal. The associated memory performs a precharge operation on a corresponding word line based on the precharge signal. The first control circuit includes: a first processing sub-circuit configured to receive the counting result and generate and output an initial supplementary refresh indication signal based on the counting result, where the generated initial supplementary refresh indication signal is at an active level only when the counting result is within the first preset range; and a first D flip-flop, where an input terminal is configured to receive the initial supplementary refresh indication signal, a clock terminal is configured to receive the precharge delay signal, and an output terminal is configured to output the supplementary refresh indication signal. The first D flip-flop is configured to sample the initial supplementary refresh indication signal based on each precharge delay signal to output and latch the supplementary refresh indication signal.

Optionally, the count flag circuit includes: a first NAND logic circuit, where a first input terminal is configured to receive the same-bank refresh flag signal, and a second input terminal is configured to receive the refresh activation signal; a second NAND logic circuit, where a first input terminal is configured to receive the all-bank refresh flag signal, and a second input terminal is configured to receive the refresh activation signal; and a second NOR logic circuit, where a first input terminal is connected to an output terminal of the first NAND logic circuit, a second input terminal is connected to an output terminal of the second NAND logic circuit, and an output terminal is configured to output the count flag signal.

Optionally, the refresh control circuit further includes: a second control circuit configured to receive the counting result and generate a count reset signal when the counting result is a preset value. The count reset signal is used to reset the counting result generated by the count processing circuit. The preset value is greater than any value within the first preset range.

Optionally, the second control circuit includes: a second processing sub-circuit configured to receive the counting result and generate a triggering signal when the counting result is the preset value; and a second D flip-flop, where an input terminal is configured to receive the triggering signal, a clock terminal is configured to receive the precharge delay signal, and an output terminal is connected to a first input terminal of a second AND logic circuit and an input terminal of a second delay circuit. An output terminal of the second delay circuit is connected to an input terminal of a second inverter, an output terminal of the second inverter is connected to a second input terminal of the second AND logic circuit, and an output terminal of the second AND logic circuit is configured to output the count reset signal.

Optionally, the count processing circuit includes: K cascaded third D flip-flops, where a clock terminal of a next third D flip-flop is connected to an inverted output terminal Q- of a previous third D flip-flop, and a clock terminal of the third D flip-flop in a first stage is configured to receive the count flag signal. An inverted output terminal of each third D flip-flop is connected to an input terminal, and the output data of an output terminal of each third D flip-flop constitutes the counting result.

Optionally, when the first preset range is [2, 3], the first processing sub-circuit includes: a first NOR logic circuit including K-2 input terminals, where the K-2 input terminals are connected to output terminals of the third D flip-flops in the last K-2 stages in one-to-one correspondence; and a third AND logic circuit, where a first input terminal is connected to an output terminal of the third D flip-flop in a second stage, a second input terminal is connected to an output terminal of the first NOR logic circuit, an output terminal is configured to output the initial supplementary refresh indication signal, and K is greater than or equal to 2.

Optionally, the second processing sub-circuit includes: a fourth AND logic circuit, where a first input terminal is connected to an output terminal of the third D flip-flop in a third stage, a second input terminal is connected to an output terminal of the third D flip-flop in a fourth stage, an output terminal is configured to output the triggering signal, and K is greater than or equal to 4.

Optionally, the first control circuit further includes: a fifth AND logic circuit, where a first input terminal is connected to the output terminal of the first D flip-flop, a second input terminal is configured to receive a self-refresh flag signal, and an output terminal is configured to output an adjusted supplementary refresh indication signal. The self-refresh flag signal indicates whether the associated memory is in a self-refresh mode, and when the associated memory is currently in the self-refresh mode, the adjusted supplementary refresh indication signal is at an inactive level.

Optionally, the count flag circuit includes: a first NAND logic circuit, where a first input terminal is configured to receive the same-bank refresh flag signal, and a second input terminal is configured to receive the refresh activation signal; a second NAND logic circuit, where a first input terminal is configured to receive the all-bank refresh flag signal, and a second input terminal is configured to receive the refresh activation signal; a second NOR logic circuit, where a first input terminal is connected to an output terminal of the first NAND logic circuit, a second input terminal is connected to an output terminal of the second NAND logic circuit, and an output terminal is configured to output the count flag signal; and a sixth AND logic circuit, where a first input terminal is connected to the output terminal of the second NOR logic circuit, a second input terminal is configured to receive the self-refresh flag signal, and an output terminal is configured to output the count flag signal.

Optionally, the refresh control circuit further includes: a signal generation circuit configured to generate the same-bank refresh flag signal.

Optionally, the signal generation circuit includes: N latches, where N is the number of banks in each bank group in the associated memory, the N latches are arranged in one-to-one correspondence with the N banks in each bank group, a set terminal of each latch is configured to receive the same-bank refresh command corresponding to the corresponding bank, and an output terminal of each latch is configured to output a corresponding bank refresh flag signal; a first AND logic circuit including N input terminals connected to the output terminals of the N latches in one-to-one correspondence and an output terminal configured to output the same-bank refresh flag signal; a first delay circuit, where an input terminal is configured to receive the same-bank refresh flag signal, and an output terminal is connected to an input terminal of a first inverter; and a third NOR logic circuit, where a first input terminal is connected to an output terminal of the first inverter, a second input terminal is configured to receive a refresh window signal, an output terminal is configured to output a reset control signal, and a reset terminal of each latch is coupled to the output terminal of the third NOR logic circuit.

Optionally, the latch includes: a fourth NOR logic circuit, where a first input terminal serves as the set terminal of the latch and is configured to receive the same-bank refresh command corresponding to the corresponding bank, a second input terminal is connected to an output terminal of a fifth NOR logic circuit, and an output terminal is connected to a first input terminal of the fifth NOR logic circuit. A second input terminal of the fifth NOR logic circuit serves as the reset terminal of the latch and is configured to receive the reset control signal, and the output terminal serves as the output terminal of the latch and is configured to output the corresponding bank refresh flag signal.

Optionally, the signal generation circuit further includes: a sixth NOR logic circuit, where a first input terminal is configured to receive the all-bank refresh command, and a second input terminal is configured to receive a self-refresh command; and a third NAND logic circuit, where a first input terminal is connected to an output terminal of the sixth NOR logic circuit, a second input terminal is connected to an output terminal of a third inverter, an output terminal is connected to the reset terminal of each latch, and an input terminal of the third inverter is configured to receive the reset control signal.

Another embodiment of the present disclosure further provides a memory. The memory includes the refresh control circuit according to the above embodiments.

### BRIEF DESCRIPTION OF DRAWINGS

One or more embodiments are exemplarily illustrated with reference to figures in the corresponding drawings, and these exemplary illustrations are not to be construed as limiting the embodiments. Unless expressly stated otherwise, the figures in the drawings do not constitute a limitation of scale. To more clearly illustrate the technical solutions in the embodiments of the present disclosure or conventional technology, a brief introduction to the drawings required to be used in the embodiments is given hereinafter. It is evident that the drawings described hereinafter are merely some embodiments of the present disclosure. For those of ordinary skill in the art, other drawings may be further obtained based on these drawings without creative effort.
FIG. 1 is a schematic diagram illustrating a principle by which a memory generates a refresh activation signal in different refresh modes according to an embodiment of the present disclosure;
FIG. 2 is a schematic structural diagram of a refresh control circuit according to an embodiment of the present disclosure;
FIG. 3 is a schematic structural diagram of another refresh control circuit according to an embodiment of the present disclosure;
FIG. 4 is a schematic diagram illustrating a principle by which a refresh control circuit performs stable row hammer protection during refresh mode switching of a memory according to an embodiment of the present disclosure;
FIG. 5 is a schematic diagram illustrating another principle by which a refresh control circuit performs stable row hammer protection during refresh mode switching of a memory according to an embodiment of the present disclosure;
FIG. 6 is a schematic structural diagram of a refresh control circuit configured to accurately generate a supplementary refresh indication signal according to an embodiment of the present disclosure;
FIG. 7 is a schematic structural diagram of a first control circuit configured to accurately generate a supplementary refresh indication signal according to an embodiment of the present disclosure;
FIG. 8 is a schematic structural diagram of a count flag circuit according to an embodiment of the present disclosure;
FIG. 9 is a schematic structural diagram of a signal generation circuit according to an embodiment of the present disclosure;
FIG. 10 is a schematic structural diagram of a latch according to an embodiment of the present disclosure;
FIG. 11 is a schematic diagram of the working principle of a signal generation circuit according to an embodiment of the present disclosure;
FIG. 12 is a schematic structural diagram of a refresh control circuit including a second control circuit according to an embodiment of the present disclosure;
FIG. 13 is a schematic structural diagram of a second control circuit according to an embodiment of the present disclosure;
FIG. 14 is a schematic structural diagram of a count processing circuit according to an embodiment of the present disclosure;
FIG. 15 is a schematic structural diagram of a first processing sub-circuit according to an embodiment of the present disclosure;
FIG. 16 is a schematic structural diagram of a second processing sub-circuit according to an embodiment of the present disclosure;
FIG. 17 is a schematic structural diagram of a refresh control circuit further configured to perform self-refresh masking according to an embodiment of the present disclosure;
FIG. 18 is a schematic structural diagram of a first control circuit further configured to perform self-refresh masking according to an embodiment of the present disclosure;
FIG. 19 is a schematic structural diagram of a count flag circuit further configured to perform self-refresh masking according to an embodiment of the present disclosure;
FIG. 20 is a schematic diagram of the principle of self-refresh masking according to an embodiment of the present disclosure;
FIG. 21 is a schematic diagram of the principle of another self-refresh masking according to an embodiment of the present disclosure; and
FIG. 22 is a schematic structural diagram of a signal generation circuit further configured to perform self-refresh masking according to an embodiment of the present disclosure.

### DESCRIPTION OF EMBODIMENTS

It can be seen from the background that various refresh modes have been introduced with the development of DRAM, and the row hammer protection is embedded in these refresh operations, but frequent switching of refresh modes may lead to vulnerabilities in the row hammer protection.

An embodiment of the present disclosure provides a refresh control circuit to provide a row hammer protection control strategy when refresh modes are frequently switched, thereby preventing the row hammer protection of a memory from being vulnerable.

Those of ordinary skill in the art can understand that in various embodiments of the present disclosure, numerous technical details are set forth to enable readers to better understand the present disclosure. However, the technical solutions claimed by the present disclosure can also be implemented even without these technical details and the various changes and modifications based on the following embodiments. The division of the following embodiments is for the convenience of description and should not constitute any limitation to the specific implementation of the present disclosure. The various embodiments may be combined or referenced with each other as long as there is no contradiction.

The following describes the refresh control circuit according to this embodiment in detail with reference to the accompanying drawings. Details are as follows.

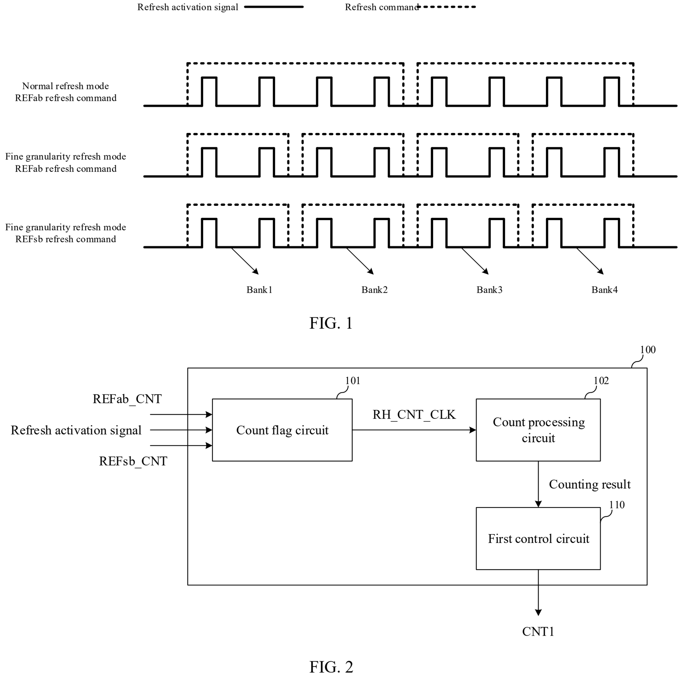

For different refresh modes of a memory, referring to FIG. 1, if the memory performs refreshes based on an all-bank refresh command REFab in a normal refresh mode, during the active period of each all-bank refresh command REFab, the memory sequentially opens four refresh windows, that is, four refresh activation signals, and each refresh window is used for refreshing target addresses of all banks; if the memory performs refreshes based on the all-bank refresh command REFab in a fine granularity refresh mode, during the active period of each all-bank refresh command REFab, the memory sequentially opens two refresh windows, that is, two refresh activation signals, and each refresh window is used for refreshing target addresses of all banks; if the memory performs refreshes based on a same-bank refresh command REFsb in the fine granularity refresh mode, during the active period of each same-bank refresh command REFsb, the memory sequentially opens two refresh windows, that is, two refresh activation signals, and each refresh window is used for refreshing a target address of a target bank.

It should be noted that the above examples of the number of refresh windows opened in different refresh modes of the memory are only used for enabling those skilled in the art to understand the implementation of this solution, and do not constitute limitations on this embodiment.

Referring to FIG. 2, a refresh control circuit 100 according to the present disclosure includes: a count flag circuit 101, a count processing circuit 102, and a first control circuit 110.

The count flag circuit 101 is configured to receive a refresh activation signal, an all-bank refresh flag signal REFab_CNT, and a same-bank refresh flag signal REFsb_CNT, and generate and output, based on each refresh activation signal, one count flag signal RH_CNT_CLK when the all-bank refresh flag signal REFab_CNT or the same-bank refresh flag signal REFsb_CNT is active.

Regarding the all-bank refresh flag signal REFab_CNT, the all-bank refresh flag signal REFab _CNT indicates that an associated memory currently performs a refresh operation based on an all-bank refresh command CMD_REFab; regarding the same-bank refresh flag signal REFsb_CNT, the same-bank refresh flag signal REFsb_CNT indicates that an associated memory currently performs a refresh operation on the last bank in each bank group based on a same-bank refresh command CMD_REFsb; the associated memory generates at least one refresh activation signal based on each all-bank refresh command CMD_REFab or each same-bank refresh command CMD_REFsb, and perform one refresh operation based on each refresh activation signal.

For the count flag signal RH_CNT_CLK, in this embodiment, a case in which the count flag signal RH_CNT_CLK, the all-bank refresh flag signal REFab_CNT, and the same-bank refresh flag signal REFsb_CNT have an active level of "1" and an inactive level of "0" is taken as an example for illustration, such that those skilled in the art can understand the refresh control circuit according to the present disclosure, and this case does not constitute limitations on this embodiment. In other embodiments, the active levels of the count flag signal, the all-bank refresh flag signal, and the same-bank refresh flag signal may be set to "0", and their inactive levels may be set to "1".

It should be noted that, in the following drawings associated with this embodiment, the same-bank refresh flag signal REFsb_CNT received by the count flag circuit 101 is provided based on a signal generation circuit 103. This is because the generation circuit of the same-bank refresh flag signal REFsb_CNT is described later in the embodiments of the present disclosure.

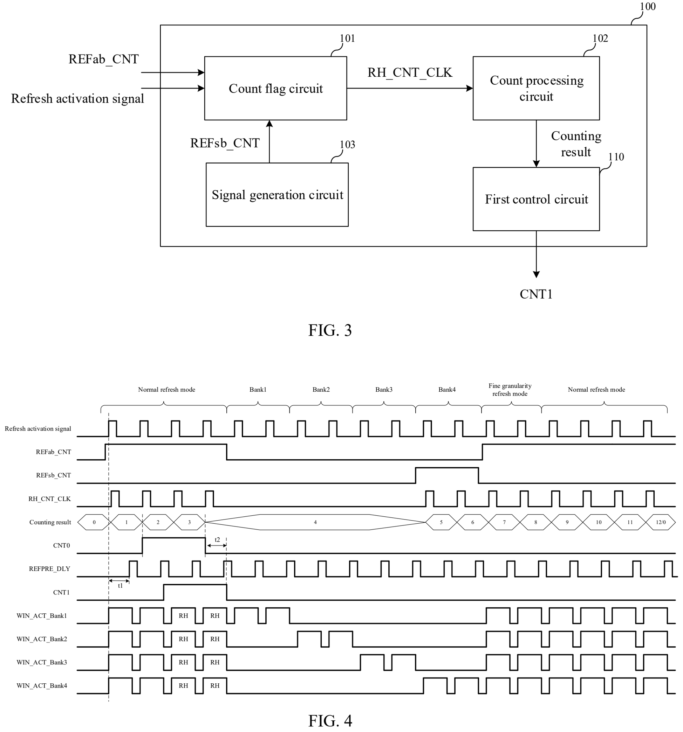

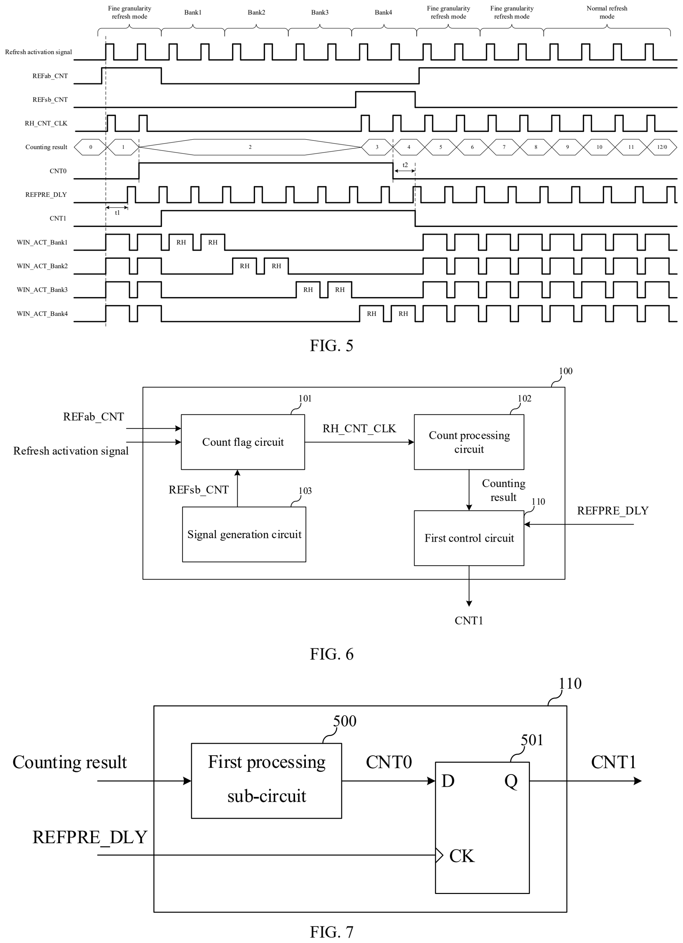

Specifically, referring to FIGS. 4 and 5, for the count flag circuit 101, the count flag circuit 101 generates and outputs one count flag signal RH_CNT_CLK based on each refresh activation signal when the all-bank refresh flag signal REFab_CNT is active; alternatively, the count flag circuit 101 generates and outputs one count flag signal RH_CNT_CLK based on each refresh activation signal when the same-bank refresh flag signal REFsb_CNT is active.

With continued reference to FIG. 2, the refresh control circuit 100 further includes the count processing circuit 102. The count processing circuit is configured to receive the count flag signal RH_CNT_CLK and count, based on the count flag signal RH_CNT_CLK, to generate a counting result.

Specifically, referring to FIGS. 4 and 5, the count processing circuit 102 counts based on the count flag signal RH_CNT_CLK, and each time the count processing circuit 102 receives one count flag signal RH_CNT_CLK, the counting result generated by the count processing circuit 102 is incremented by 1.

With continued reference to FIG. 2, the refresh control circuit 100 further includes the first control circuit 110. The first control circuit is configured to receive the counting result and generate and output, when the counting result is within a first preset range, a supplementary refresh indication signal CNT1 at an active level. The supplementary refresh indication signal CNT1, when active, indicates that the associated memory performs a supplementary refresh operation based on the all-bank refresh command REFab_CNT or the same-bank refresh command REFsb_CNT. The supplementary refresh operation is a row hammer refresh or a redundant row address refresh of the memory.

Referring to FIGS. 4 and 5, it should be noted that in this embodiment, the first control circuit 110 is specifically described with the first preset range of the counting result being [2, 3] (i.e., when the counting result is greater than or equal to "2" and less than or equal to "3"), such that those skilled in the art can understand the refresh control circuit according to the present disclosure. However, this does not constitute limitations on this embodiment. In addition, in this embodiment, a case in which the supplementary refresh indication signal CNT1 has an active level of "1" and an inactive level of "0" is taken as an example for illustration, and this case does not constitute limitations on this embodiment. In other embodiments, the active level of the supplementary refresh indication signal CNT1 may be set to "0", and the inactive level may be set to "1".

For the activation process in the refresh operation, a high level of WIN_ACT_Bank1 indicates that bank1 is currently in an activation window, a high level of WIN_ACT_Bank2 indicates that bank2 is currently in an activation window, a high level of WIN_ACT_Bank3 indicates that bank3 is currently in an activation window, and a high level of WIN_ACT_Bank4 indicates that bank4 is currently in an activation window. It can be known from the foregoing that: when the memory performs refreshes based on the all-bank refresh command CMD_REFab, the all-bank refresh flag signal REFab _CNT is active and the memory opens the activation windows of Bank1 to Bank4 based on each refresh activation signal; when the memory performs refreshes based on the same-bank refresh command CMD _REFab, the memory opens the activation windows of target memory blocks in Bank1 to Bank4 based on each refresh activation signal.

Referring to FIG. 4, when the memory is frequently switched between the following modes in sequence: the normal refresh mode, the fine granularity refresh mode with refreshing based on the same-bank refresh command CMD _REFsb, the fine granularity refresh mode with refreshing based on the all-bank refresh command CMD _REFab, and the normal refresh mode, the supplementary refresh indication signal CNT1 covers subsequent two activation windows for a specific bank after the normal refresh mode.

Referring to FIG. 5, when the memory is frequently switched between the following modes in sequence: the fine granularity refresh mode with refreshing based on the all-bank refresh command CMD _REFab, the fine granularity refresh mode with refreshing based on the same-bank refresh command CMD _REFsb, the fine granularity refresh mode with refreshing based on the all-bank refresh command CMD _REFab, and the normal refresh mode, the supplementary refresh indication signal CNT1 covers an activation window for a specific bank under the fine granularity refresh mode with refreshing based on the same-bank refresh command CMD_REFsb.

The supplementary refresh indication signal CNT1, when active, indicates that the associated memory performs a supplementary refresh based on the all-bank refresh command CMD_REFab or the same-bank refresh command CMD _REFsb. The supplementary refresh is the row hammer protection process of the memory. For the refresh control circuit 100 according to this embodiment, the row hammer protection strategy of the memory is elevated to the memory-wide level, such that the row hammer protection strategy of the memory is no longer limited to a specific refresh mode. In this case, no matter how frequently the refresh mode changes, the refresh control circuit 100 performs a supplementary refresh based on the counting result of a first preset value. That is, the row hammer protection is performed when the count of the refresh operations of the memory reaches the first preset value, thereby preventing the row hammer protection of the memory from being vulnerable.

For the refresh operation of the memory, the memory activates a word line corresponding to an address to be refreshed based on the refresh activation signal, which is the activation process in the refresh operation. After activation of the corresponding word line, memory cells connected to the word line are charged/discharged to implement the refresh process in the refresh operation. The memory receiving the refresh activation signal can be regarded as the start of the activation process in the refresh operation, and the memory completing the charging/discharging of the memory cells connected to the word line can be regarded as the end of the refresh process in the refresh operation.

In some embodiments, referring to FIG. 6, the first control circuit 110 is further configured to receive precharge delay signals REFPRE_DLY. The precharge delay signal REFPRE_DLY is a delay signal of a precharge signal, and each refresh activation signal corresponds to one precharge signal. The memory performs a precharge operation on a corresponding word line based on the precharge signal; that is, the memory cells connected to the word line are charged/discharged, as described above.

Referring to FIG. 7, the first control circuit 110 includes: a first processing sub-circuit 500 configured to receive the counting result and generate and output an initial supplementary refresh indication signal CNT0 based on the counting result, where the generated initial supplementary refresh indication signal CNT0 is at an active level only when the counting result is within the first preset range; and a first D flip-flop 501, where an input terminal D is configured to receive the initial supplementary refresh indication signal CNT0, a clock terminal CK is configured to receive the precharge delay signal REFPRE_DLY, and an output terminal is configured to output the supplementary refresh indication signal CNT1. The precharge delay signal REFPRE _DLY is a delay signal of a precharge signal for completing a precharge operation of the current corresponding word line. The associated memory performs a precharge operation on a corresponding word line based on the precharge signal, and each refresh activation signal corresponds to one precharge signal. The first D flip-flop 501 is configured to sample the initial supplementary refresh indication signal CNT0 based on each precharge delay signal REFPRE _DLY to output and latch the supplementary refresh indication signal CNT1.

With continued reference to FIGS. 4 and 5, regarding the supplementary refresh indication signal CNT1, the supplementary refresh indication signal CNT1 needs to cover the next one or more complete row hammer refresh operation processes (depending on the specific number of row hammer refresh operations caused by each supplementary refresh indication signal CNT1, which can be determined by parameter setting in a mode register), so it is necessary to delay the initial supplementary refresh indication signal CNT0 to the completion time of the current refresh operation. Specifically, by sampling CNT0 using the precharge delay signal REFPRE_DLY, the supplementary refresh indication signal CNT1 is delayed to the time of being aligned with the precharge delay signal REFPRE_DLY; the delay time may be denoted as t2, and t2 is a delay between the count flag signal RH_CNT_CLK and the precharge delay signal REFPRE _DLY.

It should be noted that, in the specific application process, t1 is a delay between the refresh activation signal and the precharge delay signal REFPRE_DLY, and t1 may represent the execution time of the current refresh operation. Since the pulse of the count flag signal has a certain delay relative to the pulse of the refresh activation signal, t2 is slightly less than t1.

The principle of generating the supplementary refresh indication signal CNT1 is that when the counting result received by the first control circuit 110 is "2" or "3", which falls within the first preset range, the first control circuit 110 generates and outputs the supplementary refresh indication signal CNT1 at the active level. The process of generating the supplementary refresh indication signal CNT1 is as follows: The first control circuit 110 generates and outputs the initial supplementary refresh indication signal CNT0 at the active level within the time period when the counting result remains "2" or "3", and then the first control circuit 110 delays the initial supplementary refresh indication signal CNT0 to generate the supplementary refresh indication signal CNT1. The purpose of the delay is to ensure that the supplementary refresh indication signal covers the refresh windows opened by the next two corresponding (i.e., the (2+1)^{th} and (3+1)^{th} refresh activation signals.

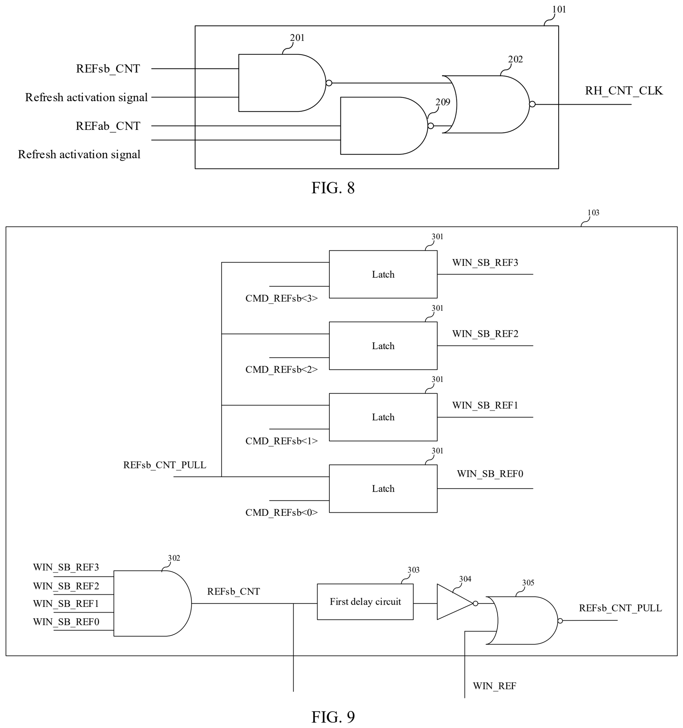

For the count flag circuit, in some embodiments, referring to FIG. 8, the count flag circuit 101 includes: a first NAND logic circuit 201, where a first input terminal is configured to receive the same-bank refresh flag signal REFsb _CNT, and a second input terminal is configured to receive the refresh activation signal; a second NAND logic circuit 209, where a first input terminal is configured to receive the all-bank refresh flag signal REFab_CNT, and a second input terminal is configured to receive the refresh activation signal; and a second NOR logic circuit 202, where a first input terminal is connected to an output terminal of the first NAND logic circuit 201, a second input terminal is connected to an output terminal of the second NAND logic circuit 209, and an output terminal is configured to output the count flag signal RH_CNT_CLK.

The count flag circuit 101 implements, based on a logic circuit composed of the first NAND logic circuit 201, the second NAND logic circuit 209, and the second NOR logic circuit 202, the algorithm logic of the count flag signal RH_CNT_CLK generated by the count flag circuit 101.

In some embodiments, as illustrated in FIGS. 3 and 6, the refresh control circuit 100 further includes a signal generation circuit configured to generate the same-bank refresh flag signal REFsb_CNT.

In one example, referring to FIG. 9, the signal generation circuit 103 includes: N latches 301, where N is the number of banks in each bank group in the associated memory, the N latches 301 are arranged in one-to-one correspondence with the N banks in each bank group, a set terminal of each latch 301 is configured to receive the same-bank refresh command CMD_REFsb corresponding to the corresponding bank, and an output terminal of each latch 301 is configured to output a corresponding bank refresh flag signal WIN_SB_REF; a first AND logic circuit 302 including N input terminals connected to the output terminals of the N latches 301 in one-to-one correspondence and an output terminal configured to output the same-bank refresh flag signal REFsb_CNT; a first delay circuit 303, where an input terminal is configured to receive the same-bank refresh flag signal REFsb_CNT, and an output terminal is connected to an input terminal of a first inverter 304; and a third NOR logic circuit 305, where a first input terminal is connected to an output terminal of the first inverter 304, a second input terminal is configured to receive a refresh window signal WIN_REF, an output terminal is configured to output a reset control signal REFsb_CNT_PULL, and a reset terminal of each latch is coupled to the output terminal of the third NOR logic circuit 305. The refresh window signal WIN_REF indicates a refresh window opened by the memory based on the same-bank refresh command CMD _REFsb. When the refresh window exists, the refresh window signal WIN_REF has an active level of "1", and when the refresh window does not exist, the refresh window signal WIN_REF has an inactive level of "0".

In one example, each memory includes M bank groups (bank groups), and each bank group (bank group) includes N banks (banks); that is, each memory includes M*N banks. In addition, as illustrated FIG. 9, a case in which each bank group includes four banks (a bank A, a bank B, a bank C, and a bank D) is taken as an example for illustration, such that those skilled in the art can understand the technical solutions of the present disclosure, and this case does not constitute limitations on this embodiment.

For a latch S1, a set terminal is configured to receive a same-bank refresh command CMD_REFsb<1> corresponding to the bank A, a reset terminal is configured to receive a reset control signal REFsb_CNT_PULL, and an output terminal is configured to output a bank refresh flag signal WIN_SB_REF0. For a latch S2, a set terminal is configured to receive a same-bank refresh command CMD_REFsb<2> corresponding to the bank B, a reset terminal is configured to receive a reset control signal REFsb_CNT _PULL, and an output terminal is configured to output a bank refresh flag signal WIN_SB_REF1. For a latch S3, a set terminal is configured to receive a same-bank refresh command CMD_REFsb<3> corresponding to the bank C, a reset terminal is configured to receive a reset control signal REFsb_CNT_PULL, and an output terminal is configured to output a bank refresh flag signal WIN_SB_REF2. For a latch S4, a set terminal is configured to receive a same-bank refresh command CMD_REFsb<4> corresponding to the bank D, a reset terminal is configured to receive a reset control signal REFsb_CNT_PULL, and an output terminal is configured to output a bank refresh flag signal WIN_SB_REF3.

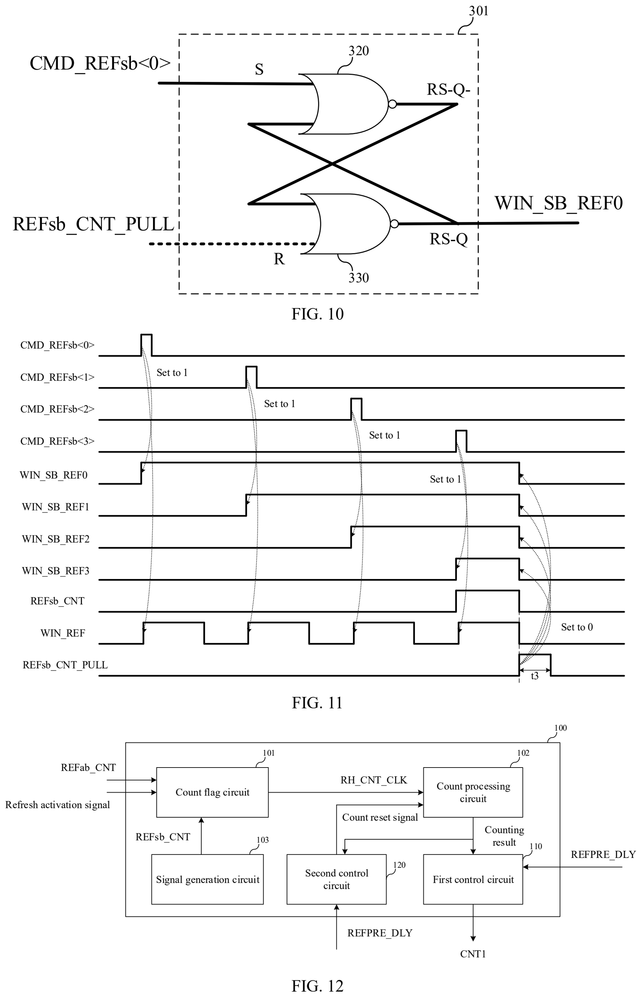

For each latch 301, in one example, the latch 301 is implemented based on an SR latch. Specifically, referring to FIG. 10, the latch 301 includes: a fourth NOR logic circuit 320, where a first input terminal serves as the set terminal of the latch 301 and is configured to receive the same-bank refresh command CMD_REFsb corresponding to the corresponding bank, a second input terminal is connected to an output terminal of a fifth NOR logic circuit 330, and an output terminal is connected to a first input terminal of the fifth NOR logic circuit 330. A second input terminal of the fifth NOR logic circuit 330 serves as the reset terminal of the latch 301 and is configured to receive the reset control signal REFsb_CNT_PULL, and the output terminal serves as the output terminal of the latch 301 and is configured to output the corresponding bank refresh flag signal WIN_SB_REF.

It should be noted that FIG. 10 illustrates a signal flow with the latch S1 as an example. Those skilled in the art may correspondingly replace the signal flow of the latch S1 with a signal flow of the latch S2, the latch S3, or the latch S4.

It should also be noted that, in other embodiments, a latch can also be implemented based on an RS latch. Those skilled in the art can modify the connection manner of the latch 301 based on the example of FIG. 10, and any such modifications that do not produce effects different from those of this embodiment shall fall within the scope of protection of the present disclosure.

Referring to FIG. 11, the latch 301 sets the output terminal based on the same-bank refresh command CMD_REFsb to generate a corresponding bank refresh flag signal WIN_SB_REF. A single same-bank refresh command CMD_REFsb is used to refresh the same bank of all bank groups. To complete the refresh of one bank group, four refresh operations need to be performed based on four corresponding same-bank refresh commands CMD _REFsb. When the last bank is refreshed, the same-bank refresh flag signal REFsb_CNT output by the first AND logic circuit 302 is set to "1", and in this case, the refresh window signal WIN_REF is "1", and the reset control signal REFsb_CNT_PULL output via the third NOR logic circuit 305 is "1". When the refresh window signal WIN_REF transitions to "0", the reset control signal REFsb_CNT_PULL output by the third NOR logic circuit 305 is set to "0". The reset control signal REFsb_CNT_PULL feeds back to control the latch 301, thereby setting the corresponding bank refresh flag signal WIN_SB_REF to "0" and setting the same-bank refresh flag signal REFsb_CNT output by the first AND logic circuit 302 to "0". After the same-bank refresh flag signal REFsb_CNT that is set to "0" is delayed by t3 via the first delay circuit 303, the reset control signal REFsb_CNT_PULL is set to "1"; that is, when the last bank of one bank group of the memory is refreshed, the signal generation circuit 103 generates an active pulse of one same-bank refresh flag signal REFsb_CNT. The delay t3 caused by the first delay circuit 303 may be set to any value.

In some embodiments, referring to FIG. 12, the refresh control circuit 100 further includes a second control circuit 120 configured to receive the counting result and generate a count reset signal when the counting result is a preset value. The count reset signal is used to reset the counting result generated by the count processing circuit 102. The preset value is greater than any value within the first preset range.

It should be noted that in this embodiment, the second control circuit 120 is specifically described with the preset value of the counting result being "12", such that those skilled in the art can understand the refresh control circuit according to the present disclosure. However, this does not constitute limitations on this embodiment.

When the counting result received by the second control circuit 120 is "12", that is, the counting result is the preset value, the second control circuit 120 generates a count reset signal. Referring to FIGS. 4 and 5, the count reset signal is transmitted to the count processing circuit 102 to reset the counting result.

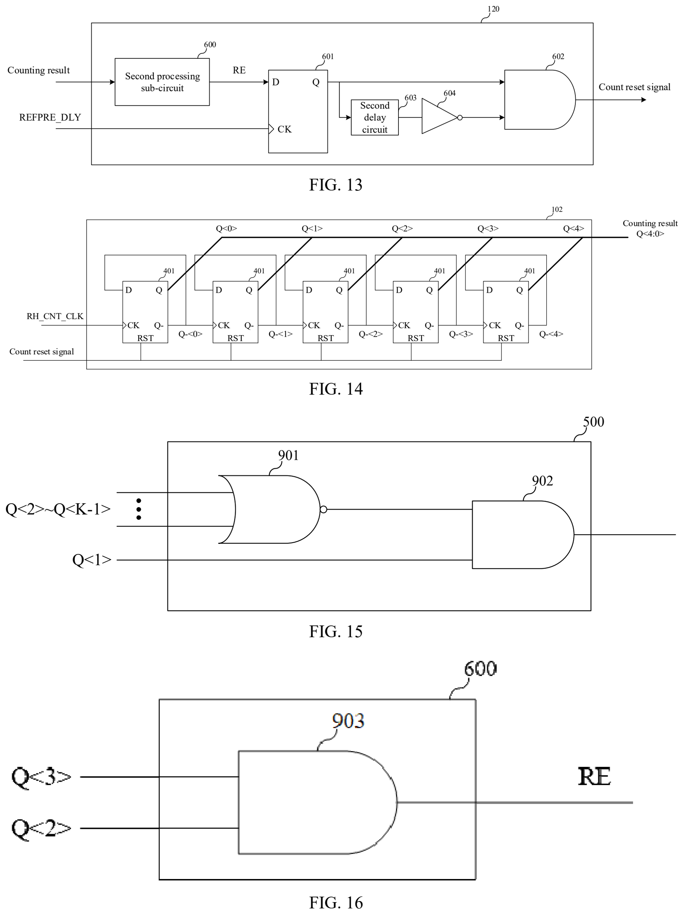

Referring to FIG. 13, the second control circuit 120 is further configured to receive a precharge delay signal REFPRE _DLY. The second control circuit 120 includes: a second processing sub-circuit 600 configured to receive the counting result and generate a triggering signal RE when the counting result is the preset value; and a second D flip-flop 601, where an input terminal is configured to receive the triggering signal RE, an output terminal is connected to a first input terminal of a second AND logic circuit 602 and an input terminal of a second delay circuit 603, and a clock terminal is configured to receive the precharge delay signal REFPRE _DLY. The output terminal of the second delay circuit 603 is connected to an input terminal of a second inverter 604, an output terminal of the second inverter 604 is connected to a second input terminal of the second AND logic circuit 602, and an output terminal of the second AND logic circuit 602 is configured to output the count reset signal.

For the count processing circuit 102, in some embodiments, referring to FIG. 14, the count processing circuit 102 includes: K cascaded third D flip-flops 401, where a clock terminal CK of a next third D flip-flop 401 is connected to an inverted output terminal Q- of a previous third D flip-flop 401, and a clock terminal CK of the third D flip-flop 401 in a first stage is configured to receive the count flag signal RH_CNT_CLK. An inverted output terminal Q- of each third D flip-flop 401 is connected to an output terminal D, and the output data of an output terminal of each third D flip-flop 401 constitutes the counting result.

It should be noted that in FIG. 14, a case in which the count processing circuit 102 is constituted by third D flip-flops 401 cascaded in five stages is taken as an example for illustration, and this case does not constitute limitations on the count processing circuit 102. In specific applications, a specific value of K may be set based on a specific application scenario.

For the circuit illustrated in FIG. 14, the data output by the third D flip-flop in a first stage is Q<0>, the data output by the third D flip-flop in a second stage is Q<1>, the data output by the third D flip-flop in a third stage is Q<2>, the data output by the third D flip-flop in a fourth stage is Q<3>, the data output by the third D flip-flop in a fifth stage is Q<4>, and the data output by the third D flip-flops from the first through the fifth stages constitute the counting result Q<4:0>.

When the count flag signal RH_CNT_CLK is active, the data Q<0> output by the third D flip-flop in the first stage is set to "1", and in this case, the inverted output terminal Q- is set to "0", generating a falling edge. Since the third D flip-flop 401 is configured as rising-edge triggered, the subsequent third D flip-flops do not work. When one count flag signal RH_CNT_CLK is active, the data Q<0> output by the third D flip-flop in the first stage is set to "0", and in this case, the inverted output terminal Q- is set to "1", generating a rising edge. Then, the third D flip-flop in the second stage is set to "1" based on this rising edge, and so on, thereby implementing counting based on the cascaded third D flip-flops 401.

When the data Q<0> output by the third D flip-flop in the first stage is "1", the output result is 1; when the data Q<1> output by the third D flip-flop in the second stage is "1", the output result is 2; when the data Q<2> output by the third D flip-flop in the third stage is "1", the output result is 4; when the data Q<3> output by the third D flip-flop in the fourth stage is "1", the output result is 8; when the data Q<4> output by the third D flip-flop in the fifth stage is "1", the output result is 16. The counting result is the sum of all output results. In this case, the count processing circuit 102 is capable of counting from 0 to 32.

Based on the above description, the first processing sub-circuit 500 is configured to sample a counting result within the first preset range, and the first preset range is "2" or "3". In this case, the first processing sub-circuit 500 may be configured as a logic circuit formed by a NOR gate and an AND gate. Referring to FIG. 15, the first processing sub-circuit 500 includes: a first NOR logic circuit 901 including K-2 input terminals, where the K-2 input terminals are connected to output terminals of the third D flip-flops 401 in the last K-2 stages in one-to-one correspondence; and a third AND logic circuit 902, where a first input terminal is connected to an output terminal of the third D flip-flop 401 in a second stage, a second input terminal is connected to an output terminal of the first NOR logic circuit 901, an output terminal is configured to output the initial supplementary refresh indication signal CNT0, and K is greater than or equal to 2. If and only if the output of Q<2>-Q<K-1> is "0" and the output of Q<1> is "1", the initial supplementary refresh indication signal CNT0 output by the first processing sub-circuit 500 is at an active level. In this case, Q<0> may be output as "1" or "0", such that an active initial supplementary refresh indication signal CNT0 is output based on the counting results of 2 and 3.

It should be noted that in practical applications, if K = 2, then K-1 < 2, and the most significant count value of the counting result is Q<1>. In this case, the first NOR logic circuit 901 is not required to be included in the first processing sub-circuit 500.

Based on the above description, the second processing sub-circuit 600 is configured to sample a counting result of the preset value, and the preset value is "12". In this case, the second processing sub-circuit 600 may be configured as a logic circuit formed by a NOR gate and an AND gate. Referring to FIG. 16, the second processing sub-circuit 600 includes: a fourth AND logic circuit 903, where a first input terminal is connected to an output terminal of the third D flip-flop 401 in a third stage, a second input terminal is connected to an output terminal of the third D flip-flop 401 in a fourth stage, and an output terminal is configured to output the triggering signal RE. If and only if the output of Q<3> and Q<4> is "1", the triggering signal RE output by the second processing sub-circuit 600 is at an active level, such that an active triggering signal RE is output based on the counting result of 12.

Referring to FIGS. 13 and 14, the count reset signal is used to reset each third D flip-flop 401, such that the counting result is reset to "0"; that is, each time the count processing circuit 102 counts up to a preset value, one cycle is completed. In this cycle, the row hammer protection of the memory is performed when the counting result is within the first preset range, thereby preventing the row hammer protection of the memory from being vulnerable.

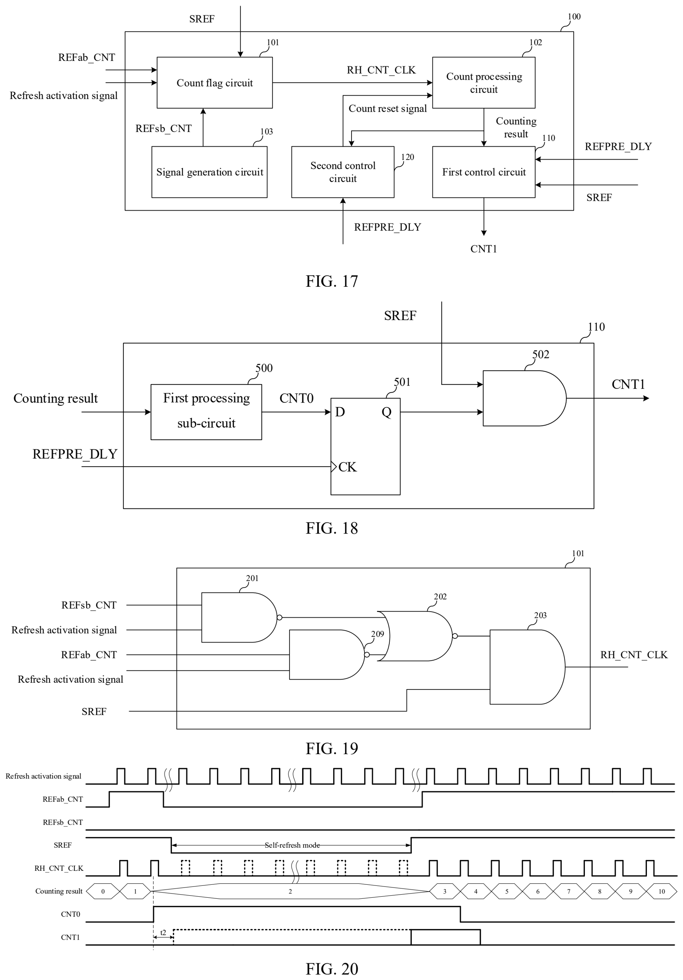

Since the memory does not require the row hammer protection during the self-refresh process, in some embodiments, referring to FIGS. 17 and 18, the first control circuit 110 is further configured to perform self-refresh masking. That is, the memory does not generate a supplementary refresh indication signal CNT1 during the self-refresh process.

Specifically, the first control circuit 110 further includes: a fifth AND logic circuit 502, where a first input terminal is connected to the output terminal of the first D flip-flop 501, a second input terminal is configured to receive a self-refresh flag signal SREF, and an output terminal is configured to output an adjusted supplementary refresh indication signal CNT1. The self-refresh flag signal SREF indicates whether the associated memory is in a self-refresh mode, and when the associated memory is currently in the self-refresh mode, the self-refresh flag signal SREF is an inactive signal, and the adjusted supplementary refresh indication signal is at an inactive level, such that the row hammer protection is not performed for the memory within a counting cycle in which the self-refresh mode is involved.

For the self-refresh flag signal SREF, in this embodiment, a case in which the self-refresh flag signal SREF has an active level of "1" and an inactive level of "0" is taken as an example for specific illustration, and this case does not constitute limitations on this embodiment. In other embodiments, the active level of the self-refresh flag signal SREF may be set to "0", and the inactive level may be set to "1".

In some embodiments, in order to avoid the influence of the self-refresh mode on the count of the count processing circuit 102, in some embodiments, referring to FIGS 17 and 19, the count flag circuit 101 is further configured to generate and output the count flag signal RH_CNT_CLK at an inactive level when the self-refresh flag signal SREF is inactive. The self-refresh flag signal SREF indicates whether the associated memory is in the self-refresh mode, and the self-refresh flag signal SREF is an inactive signal when the memory is currently in the self-refresh mode.

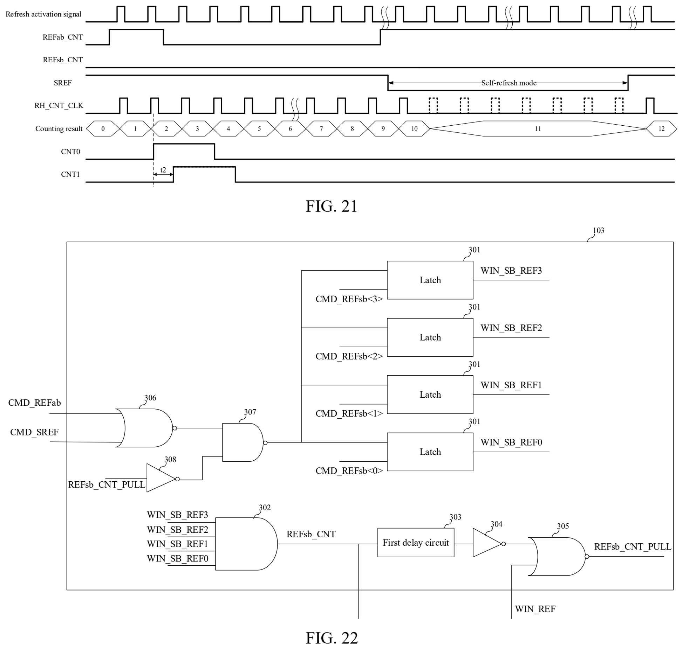

Specifically, referring to FIG. 19, the count flag circuit 101 includes: a first NAND logic circuit 201, where a first input terminal is configured to receive the same-bank refresh flag signal REFsb _CNT, and a second input terminal is configured to receive the refresh activation signal; a second NAND logic circuit 209, where a first input terminal is configured to receive the all-bank refresh flag signal REFab_CNT, and a second input terminal is configured to receive the refresh activation signal; a second NOR logic circuit 202, where a first input terminal is connected to an output terminal of the first NAND logic circuit 201, and a second input terminal is connected to an output terminal of the second NAND logic circuit 209; and a sixth AND logic circuit 203, where a first input terminal is connected to an output terminal of the second NOR logic circuit 202, a second input terminal is configured to receive the self-refresh flag signal SREF, and an output terminal is configured to output the count flag signal RH_CNT_CLK. In one case, referring to FIG. 20, the counting of the refresh activation signal in the self-refresh mode is avoided by using the sixth AND logic circuit 203, and then the initial supplementary refresh flag signal CNT0 in the self-refresh mode is masked by using the fifth AND logic circuit 502, thereby preventing the refresh activation signal in the self-refresh mode from affecting the row hammer protection strategy. In another case, referring to FIG. 21, the counting of the refresh activation signal in the self-refresh mode is avoided by using the sixth AND logic circuit 203, thereby preventing the refresh activation signal in the self-refresh mode from affecting the counting.

In addition, the same-bank refresh flag signal REFsb_CNT should be be generated when the last bank of a bank group of the memory is refreshed. In order to prevent the interference of the refresh mode change on the generation of the same-bank refresh flag signal REFsb _CNT, in some embodiments, referring to FIG. 22, the signal generation circuit 103 further includes: a sixth NOR logic circuit 306, where a first input terminal is configured to receive the all-bank refresh command CMD _REFab, and a second input terminal is configured to receive a self-refresh command CMD_SREF; and a third NAND logic circuit 307, where a first input terminal is connected to an output terminal of the sixth NOR logic circuit 306, a second input terminal is connected to an output terminal of a third inverter 308, an output terminal is connected to the reset terminal of each latch 301, and an input terminal of the third inverter 308 is configured to receive the reset control signal REFsb_CNT _PULL. That is, if the refresh mode changes in the process of refreshing the memory based on the same-bank refresh command CMD _REFsb, the signal generation circuit 103 directly resets the latch 301 based on the self-refresh command CMD_SREF and the all-bank refresh command CMD _REFab, such that the same-bank refresh flag signal REFsb_CNT is not generated, thereby ensuring the generation logic of the same-bank refresh flag signal REFsb _CNT.

For the refresh control circuit according to this embodiment, the row hammer protection strategy of the memory is elevated to the memory-wide level, such that the row hammer protection strategy of the memory is no longer limited to a specific refresh mode. In this case, no matter how frequently the refresh mode changes, the refresh control circuit performs a supplementary refresh based on the counting result of a first preset value. That is, the row hammer protection is performed when the count of the refresh operations of the memory reaches the first preset value, thereby preventing the row hammer protection of the memory from being vulnerable.

It should be noted that the features disclosed in the refresh control circuit according to the above embodiments can be combined arbitrarily provided that there is no conflict and thus new refresh control circuit embodiments can be obtained.

Another embodiment of the present disclosure provides a memory, which includes the refresh control circuit according to the above embodiments to provide a row hammer protection control strategy when refresh modes are frequently switched, thereby preventing the row hammer protection of a memory from being vulnerable.

Specifically, the row hammer protection strategy of the memory is elevated to the memory-wide level, such that the row hammer protection strategy of the memory is no longer limited to a specific refresh mode. In this case, no matter how frequently the refresh mode changes, the refresh control circuit performs a supplementary refresh based on the counting result of a first preset value. That is, the row hammer protection is performed when the count of the refresh operations of the memory reaches the first preset value, thereby preventing the row hammer protection of the memory from being vulnerable.

It should be noted that the memory may be a memory cell or an apparatus based on semiconductor apparatuses or components. For example, the memory apparatus may be a volatile memory, such as a dynamic random access memory DRAM, a synchronous dynamic random access memory SDRAM, a double data rate synchronous dynamic random access memory DDR SDRAM, a low-power double data rate synchronous dynamic random access memory LPDDR SDRAM, a graphics double data rate synchronous dynamic random access memory GDDR SDRAM, a double data rate 2 synchronous dynamic random access memory DDR2 SDRAM, a double data rate 3 synchronous dynamic random access memory DDR3 SDRAM, a double data rate 4 synchronous dynamic random access memory DDR4 SDRAM, a thyristor random access memory TRAM, or the like; or the memory apparatus may be a non-volatile memory, such as a phase change random access memory PRAM, a magnetic random access memory MRAM, a resistive random access memory RRAM, or the like.

Those of ordinary skill in the art can understand that the above embodiments are specific embodiments of practicing the present disclosure, while in practical application, various changes can be made to the implementations in form and detail without departing from the spirit and scope of the present disclosure.

## Claims

1. A refresh control circuit (100), comprising:
a count flag circuit (101) configured to receive refresh activation signals, an all-bank refresh flag signal (REFab_CNT), and a same-bank refresh flag signal (REFsb_CNT), and generate and output, based on each of the refresh activation signals, one count flag signal (RH_CNT_CLK) when the all-bank refresh flag signal (REFab_CNT) or the same-bank refresh flag signal (REFsb_CNT) is active,
wherein the all-bank refresh flag signal (REFab _CNT) indicates that an associated memory currently performs a refresh operation based on an all-bank refresh command (CMD_REFab), the same-bank refresh flag signal (REFsb_CNT) indicates that the associated memory currently performs a refresh operation on the last bank in each bank group based on a same-bank refresh command (CMD_REFsb), and the associated memory generates at least one refresh activation signal based on each all-bank refresh command (CMD_REFab) or each same-bank refresh command (CMD_REFsb), and performs one refresh operation based on each of the at least one refresh activation signal;
a count processing circuit (102) configured to receive the count flag signal (RH_CNT_CLK) and count based on the count flag signal (RH_CNT_CLK) to generate a counting result; and
a first control circuit (110) configured to receive the counting result and generate and output, when the counting result is within a first preset range, a supplementary refresh indication signal (CNT1) at an active level, wherein the supplementary refresh indication signal (CNT1), when active, indicates that the associated memory performs a supplementary refresh operation based on the all-bank refresh command (CMD_REFab) or the same-bank refresh command (CMD_REFsb).

2. The refresh control circuit according to claim 1, wherein the first control circuit (110) is further configured to receive precharge delay signals (REFPRE_DLY), wherein each of the precharge delay signals (REFPRE_DLY) is a delay signal of a precharge signal, each of the refresh activation signals corresponds to one precharge signal, and the associated memory performs a precharge operation on a corresponding word line based on the precharge signal; the first control circuit (110) comprises:
a first processing sub-circuit (500) configured to receive the counting result and generate and output an initial supplementary refresh indication signal (CNTO) based on the counting result, wherein the generated initial supplementary refresh indication signal (CNTO) is at an active level only when the counting result is within the first preset range; and
a first D flip-flop (501), wherein an input terminal (D) is configured to receive the initial supplementary refresh indication signal (CNTO), a clock terminal (CK) is configured to receive the precharge delay signal (REFPRE_DLY), and an output terminal (Q) is configured to output the supplementary refresh indication signal (CNT1);
the first D flip-flop (501) is configured to sample the initial supplementary refresh indication signal (CNTO) based on each of the precharge delay signals (REFPRE_DLY) to output and latch the supplementary refresh indication signal (CNT1).

3. The refresh control circuit according to claim 1 or 2, wherein the count flag circuit (101) comprises:
a first NAND logic circuit (201), wherein a first input terminal is configured to receive the same-bank refresh flag signal (REFsb_CNT), and a second input terminal is configured to receive the refresh activation signal;
a second NAND logic circuit (209), wherein a first input terminal is configured to receive the all-bank refresh flag signal (REFab_CNT), and a second input terminal is configured to receive the refresh activation signal; and
a second NOR logic circuit (202), wherein a first input terminal is connected to an output terminal of the first NAND logic circuit (201), a second input terminal is connected to an output terminal of the second NAND logic circuit (209), and an output terminal is configured to output the count flag signal (RH_CNT_CLK).

4. The refresh control circuit according to claim 2, further comprising: a second control circuit (120) configured to receive the counting result and generate a count reset signal when the counting result is a preset value, wherein the count reset signal is used to reset the counting result generated by the count processing circuit (102), and the preset value is greater than any value within the first preset range.

5. The refresh control circuit according to claim 4, wherein the second control circuit (120) comprises:
a second processing sub-circuit (600) configured to receive the counting result and generate a triggering signal (RE) when the counting result is the preset value; and
a second D flip-flop (601), wherein an input terminal is configured to receive the triggering signal (RE), a clock terminal is configured to receive the precharge delay signal (REFPRE_DLY), and an output terminal is connected to a first input terminal of a second AND logic circuit (602) and an input terminal of a second delay circuit (603);
an output terminal of the second delay circuit (603) is connected to an input terminal of a second inverter (604), an output terminal of the second inverter (604) is connected to a second input terminal of the second AND logic circuit (602), and an output terminal of the second AND logic circuit (602) is configured to output the count reset signal.

6. The refresh control circuit according to claim 5, wherein the count processing circuit (102) comprises:
K cascaded third D flip-flops (401), wherein a clock terminal (CK) of a next third D flip-flop (401) is connected to an inverted output terminal (Q-) of a previous third D flip-flop (401), and a clock terminal (CK) of the third D flip-flop (401) in a first stage is configured to receive the count flag signal (RH_CNT_CLK);
an inverted output terminal (Q-) of each of the third D flip-flops (401) is connected to an input terminal (D), and output data of an output terminal (Q) of each of the third D flip-flops (401) constitutes the counting result.

7. The refresh control circuit according to claim 6, wherein when the first preset range is [2, 3], the first processing sub-circuit (500) comprises:
a first NOR logic circuit (901) comprising K-2 input terminals, wherein the K-2 input terminals are connected to output terminals of the third D flip-flops (401) in the last K-2 stages in one-to-one correspondence; and
a third AND logic circuit (902), wherein a first input terminal is connected to an output terminal of the third D flip-flop (401) in a second stage, a second input terminal is connected to an output terminal of the first NOR logic circuit (901), an output terminal is configured to output the initial supplementary refresh indication signal (CNTO), and K is greater than or equal to 2.

8. The refresh control circuit according to claim 6, wherein the second processing sub-circuit (600) comprises:
a fourth AND logic circuit (903), wherein a first input terminal is connected to an output terminal of the third D flip-flop (401) in a third stage, a second input terminal is connected to an output terminal of the third D flip-flop (401) in a fourth stage, an output terminal is configured to output the triggering signal (RE), and K is greater than or equal to 4.

9. The refresh control circuit according to any one of claims 2 to 8, wherein the first control circuit (110) further comprises:
a fifth AND logic circuit (502), wherein a first input terminal is connected to the output terminal of the first D flip-flop (501), a second input terminal is configured to receive a self-refresh flag signal (SREF), and an output terminal is configured to output an adjusted supplementary refresh indication signal (CNT1),
wherein the self-refresh flag signal (SREF) indicates whether the associated memory is in a self-refresh mode, and when the associated memory is currently in the self-refresh mode, the adjusted supplementary refresh indication signal (CNT1) is at an inactive level.

10. The refresh control circuit according to claim 9, wherein the count flag circuit (101) comprises:
a first NAND logic circuit (201), wherein a first input terminal is configured to receive the same-bank refresh flag signal (REFsb_CNT), and a second input terminal is configured to receive the refresh activation signal;
a second NAND logic circuit (209), wherein a first input terminal is configured to receive the all-bank refresh flag signal (REFab_CNT), and a second input terminal is configured to receive the refresh activation signal;
a second NOR logic circuit (202), wherein a first input terminal is connected to an output terminal of the first NAND logic circuit (201), a second input terminal is connected to an output terminal of the second NAND logic circuit (209), and an output terminal is configured to output the count flag signal (RH_CNT_CLK); and
a sixth AND logic circuit (203), wherein a first input terminal is connected to the output terminal of the second NOR logic circuit (202), a second input terminal is configured to receive the self-refresh flag signal (SREF), and an output terminal is configured to output the count flag signal (RH_CNT_CLK).

11. The refresh control circuit according to any one of claims 1 to 10, further comprising: a signal generation circuit (103) configured to generate the same-bank refresh flag signal (REFsb_CNT).

12. The refresh control circuit according to claim 11, wherein the signal generation circuit (103) comprises:
N latches (301), wherein N is the number of banks in each bank group in the associated memory, the N latches (301) are arranged in one-to-one correspondence with the N banks in each bank group, a set terminal of each of the latches (301) is configured to receive the same-bank refresh command (CMD_REFsb) corresponding to the corresponding bank, and an output terminal of each of the latches (301) is configured to output a corresponding bank refresh flag signal (WIN_SB_REF);
a first AND logic circuit (302) comprising N input terminals connected to the output terminals of the N latches (301) in one-to-one correspondence and an output terminal configured to output the same-bank refresh flag signal (REFsb_CNT);
a first delay circuit (303), wherein an input terminal is configured to receive the same-bank refresh flag signal (REFsb_CNT), and an output terminal is connected to an input terminal of a first inverter (304); and
a third NOR logic circuit (305), wherein a first input terminal is connected to an output terminal of the first inverter (304), a second input terminal is configured to receive a refresh window signal (WIN_REF), an output terminal is configured to output a reset control signal (REFsb_CNT_PULL), and a reset terminal of each of the latches (301) is coupled to the output terminal of the third NOR logic circuit (305).

13. The refresh control circuit according to claim 12, wherein the latch (301) comprises:
a fourth NOR logic circuit (320), wherein a first input terminal serves as the set terminal of the latch (301) and is configured to receive the same-bank refresh command (CMD_REFsb) corresponding to the corresponding bank, a second input terminal is connected to an output terminal of a fifth NOR logic circuit (330), and an output terminal is connected to a first input terminal of the fifth NOR logic circuit (330);
a second input terminal of the fifth NOR logic circuit (330) serves as the reset terminal of the latch (301) and is configured to receive the reset control signal (REFsb_CNT_PULL), and the output terminal serves as the output terminal of the latch (301) and is configured to output the corresponding bank refresh flag signal (WIN_SB_REF).

14. The refresh control circuit according to claim 12 or 13, wherein the signal generation circuit (103) further comprises:
a sixth NOR logic circuit (306), wherein a first input terminal is configured to receive the all-bank refresh command (CMD_REFab), and a second input terminal is configured to receive a self-refresh command (CMD_SREF); and
a third NAND logic circuit (307), wherein a first input terminal is connected to an output terminal of the sixth NOR logic circuit (306), a second input terminal is connected to an output terminal of a third inverter (308), an output terminal is connected to the reset terminal of each of the latches (301), and an input terminal of the third inverter (308) is configured to receive the reset control signal (REFsb_CNT_PULL).

15. A memory, comprising the refresh control circuit according to any one of claims 1 to 14.
